**Europäisches Patentamt**

**European Patent Office**

**Office européen des brevets**

(11) Numéro de publication: **0 227 512**
**B1**

(12) **FASCICULE DE BREVET EUROPEEN**

(45) Date de publication du fascicule du brevet:
23.05.90

(51) Int. Cl.⁵: **G01N 24/08**

(21) Numéro de dépôt: **86402494.8**

(22) Date de dépôt: **07.11.86**

(54) **Appareil d'imagerie par résonance magnétique nucléaire.**

(30) Priorité: **12.11.85 FR 8516668**

(43) Date de publication de la demande:
**01.07.87 Bulletin 87/27**

(45) Mention de la délivrance du brevet:
**23.05.90 Bulletin 90/21**

(84) Etats contractants désignés:
**DE GB NL**

(56) Documents cités:
**EP-A- 0 127 850**
**EP-A- 0 132 336**
**JP-A-60 151 547**

**ELECTRO/84. CONFERENCE
RECORD, 15-17 mai 1984, Boston, US,
Section 24/2, pages 1-10; Z.J.J. STEKLY: "Nuclear
magnetic resonance imaging" maging"
ELECTROMEDICA, vol. 51, no. 2, 1983, pages 65-72;
Erlangen, DE; H. MORNEBURG: "Gesichtspunkte bei
der Standortsuche und Planung für ein Magnetom"**

(73) Titulaire: **GENERAL ELECTRIC CGR S.A., 100, rue
Camille-Desmoulins, F-92130 Issy les Moulineaux(FR)**

(72) Inventeur: **Leroux, Patrick, THOMSON-CSF
SCPI 19, avenue de Messine, F-75008 Paris(FR)**

(74) Mandataire: **Ballot, Paul Denis Jacques et al, Cabinet
Ballot-Schmit 7, rue le Sueur, F-75116 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

## Description

La présente invention a pour objet un appareil d'imagerie par résonance magnétique nucléaire. Elle trouve plus particulièrement son application dans le domaine médical où l'imagerie par résonance magnétique nucléaire est unanimement reconnue comme aide au diagnostic. Elle peut bien entendu être mise en oeuvre dans d'autres domaines. Le but de la présente invention est de faire disparaître des images obtenues les fantômes qui s'y installent et qui la voilent.

Un appareil d'imagerie par résonance magnétique nucléaire comporte essentiellement trois types de bobines. Un premier type de bobines a pour objet de créer un champ magnétique homogène intense $B_0$ dans un espace prédéterminé d'intérêt. Un deuxième type de bobines, dites radiofréquence, a pour but de soumettre un corps examiné et placé sous l'influence du champ des premières bobines à des séquences d'excitation radiofréquence, et de mesurer un signal radiofréquence réémis en retour par des particules du corps. La réponse radiofréquence est une réponse en volume : toutes les particules d'une région du corps soumises à l'examen émettent en même temps leur réponse radiofréquence. Pour créer une image, il est nécessaire de différencier ces réponses. A cette fin, les appareils d'imagerie comportent des troisièmes types de bobines, dites de gradient, pour superposer au champ intense des composantes d'un champ magnétique supplémentaire. La valeur de ces composantes est fonction des coordonnées dans l'espace de leur lieu d'application. Autrement dit, chaque lieu de l'espace peut être codé par une valeur de champ différente : on exploite dans le signal réémis les modifications qui en résultent pour créer les images.

Les images ainsi obtenues sont affectées par des défauts de différentes natures. Certains défauts ont pu être reconnus parce qu'ils apparaissent d'une manière systématique. Les raisons de leur apparence ont alors pu être discriminées. Dans tous les cas où cela a été possible, on a perfectionné les systèmes d'imagerie, c'est-à-dire les appareils et les procédés d'utilisation des appareils, de manière à les faire disparaître. D'autres défauts, appelés aussi fantômes, sont plus insaisissables. Pour des images d'une même coupe d'un corps, prises selon des procédures identiques, ils peuvent être présents ou absents. Cette présence non systématique est gênante. En effet, dans ces conditions, l'interprétation de l'image est aléatoire puisqu'on ne sait pas si elle comporte des fantômes.

La présente invention a pour objet de remédier aux inconvénients cités en faisant disparaître des images les fantômes non systématiques. Dans l'invention on s'est attaché à regarder l'allure, quand ils apparaissent, de ces fantômes. On a découvert que ces fantômes correspondaient à des duplications, décalées, de l'image normale. On a de plus découvert que le décalage était proportionnel à la durée des séquences et que sa valeur, en fonction de cette durée, variait d'une manière cyclique. Pour une image d'une grandeur donnée, le décalage s'exprime en fonction de la durée des séquences d'expérimentation modulo la dimension de l'image. On a par ailleurs découvert que ce décalage était également proportionnel à la fréquence d'oscillation du signal de secteur qui alimente en puissance électrique les différentes parties de l'appareil. En définitive, si l'acquisition d'une image nécessite des séquences d'expérimentation de durée $T_r$, et si $f_0$ est la fréquence du secteur (50 hertz en Europe et 60 hertz sur le continent américain), on a découvert que le décalage était proportionnel aux produits $f_0 . T_r$. Dans l'invention, profitant de l'aspect cyclique de la valeur de ce décalage, on s'arrange pour que ce produit soit un nombre entier. De cette manière, les fantômes, quand ils apparaissent, viennent exactement se superposer à l'image originale. Dans ces conditions, ils ne la troublent plus.

L'invention a pour objet un appareil d'imagerie par résonance magnétique nucléaire comportant des moyens pour soumettre un corps à un champ magnétique continu intense, des moyens pour le soumettre à des séquences d'excitation électromagnétique, des moyens pour lui appliquer au cours des séquences des champs magnétiques supplémentaires, et des moyens pour recevoir, traiter, et représenter un signal de résonance magnétique émis en réponse par le corps, caractérisé en ce qu'il comporte des moyens de synchronisation pour que les durées des séquences soient des multiples entiers de la période d'un signal alternatif de puissance qui sert d'alimentation électrique à l'appareil.

L'invention sera mieux comprise à la lecture de la description qui suit et à l'examen des figures qui l'accompagnent. Sur celles-ci les mêmes repères désignent les mêmes éléments. Elles ne sont données qu'à titre indicatif et nullement limitatif de l'invention. Elles montrent :

- figure 1 : un appareil d'imagerie conforme à l'invention ;
- figure 2 : des diagrammes temporels de signaux intervenant dans un procédé d'imagerie mise en oeuvre, à titre d'exemple, dans l'invention ;
- figure 3 : un diagramme fonctionnel d'un exemple de réalisation des moyens de synchronisation selon l'invention ;
- figure 4 : l'allure des fantômes d'une image élémentaire ;
- figure 5 : un perfectionnment de l'invention dans une application médicale particulière.

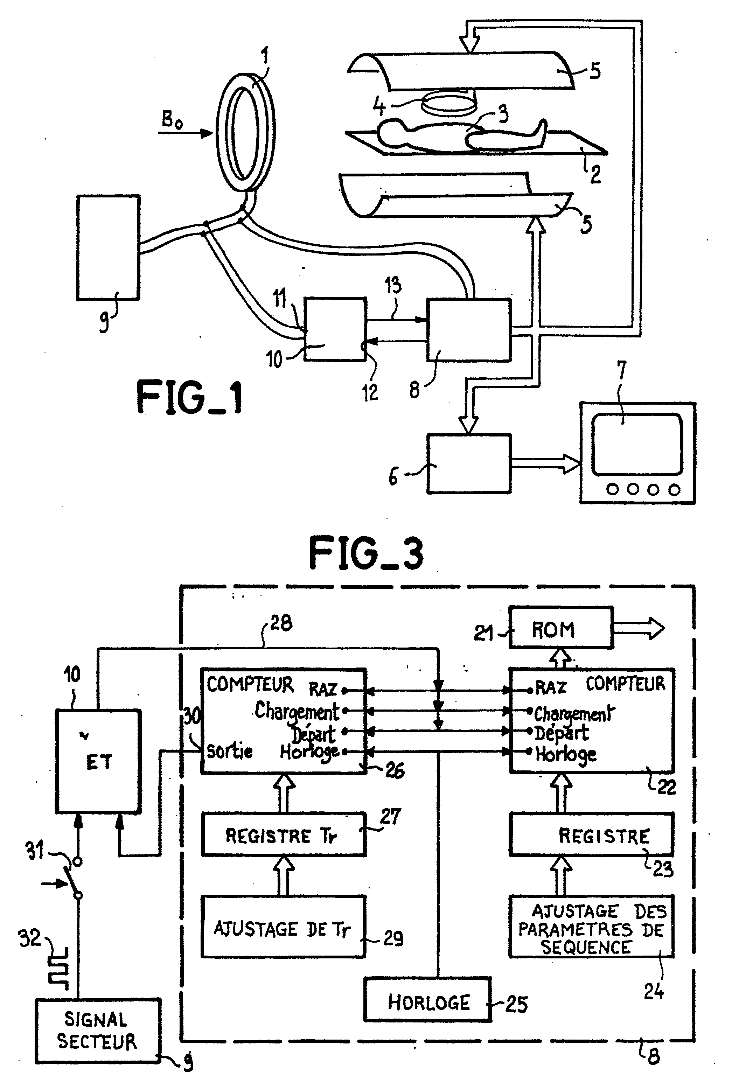

La figure 1 représente un appareil d'imagerie par résonance magnétique nucléaire conforme à l'invention. Cet appareil comporte une bobine 1 d'un premier type pour produire un champ magnétique continu intense $B_0$. Supporté par des moyens mécaniques 2 un corps 3 est soumis à l'influence du champ $B_0$. L'appareil comporte en outre des moyens 4 pour soumettre le corps ainsi sous influence à des séquences d'excitation électromagnétique. Les moyens 4 servent également à recevoir un signal radiofréquence réémis en réponse par le corps. Des moyens 5 sont prévus pour appliquer les champs magnétiques supplémentaires (ceux qui effectuent le codage) au cours des séquences. Le dispositif comporte encore des moyens 6 et 7 pour traiter et représenter le signal de résonance magnétique émis en réponse par le corps 3. Hormis le champ $B_0$ qui est en général produit d'une manière permanente, les organes de l'appareil sont pilotés par un séquenceur 8. Le séquenceur 8 détermine en particulier les durées des séquences d'excitation en fonction d'un type d'image particulier recherché.

Tous ces moyens sont alimentés par des moyens 9 de distribution de la puissance électrique. Les moyens 9, sont communément appelés secteur. En Europe, le signal secteur est un signal alternatif sinusoïdal oscillant généralement à une fréquence de 50 hertz, sur le continent américain cette fréquence peut valoir 60 hertz. Ce qui caractérise l'invention est que l'appareil comporte des moyens 10 de synchronisation pour que les durées des séquences soient des multiples entiers de la période du signal secteur. A cet effet, les moyens de synchronisation 10 recoivent sur une entrée 11 le signal secteur et sur une entrée 12 une information correspondant à une durée désirée de séquence. Par une sortie 13 les moyens 10 délivrent un signal de synchronisation au séquenceur 8 pour que celui-ci déclenche des séquences suivantes à des dates synchrones du signal secteur.

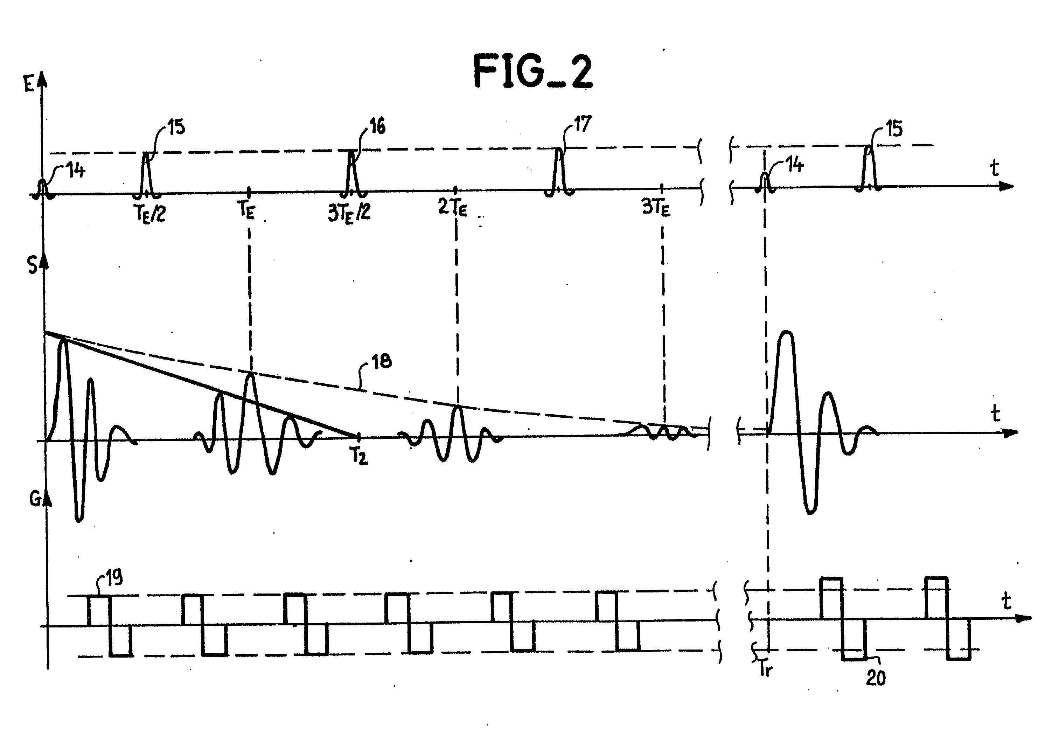

La figure 2 représente des diagrammes temporels de signaux mis en oeuvre dans un exemple de procédé d'imagerie. Le diagramme E montre des signaux d'excitation pour exciter le corps 3 à une fréquence radiofréquence de résonance. Le diagramme G montre, schématiquement, des champs supplémentaires, dits gradients, pour coder les régions de l'espace et les différentes séquences. Puis on extrait une image d'un signal S recueilli. Le signal S est reçu par les moyens 4 après chaque excitation. Dans l'exemple représenté, le signal d'excitation comporte, pour chaque séquence, une première impulsion radiofréquence 14 destinée à faire basculer de 90° les moments magnétiques des particules du corps 3. Dès la fin de cette excitation, le corps restitue un signal S s'atténuant rapidement avec le temps. Au bout d'une durée $T_E/2$ une autre impulsion radiofréquence 15 est émise. Elle a pour objet de provoquer une réflexion de la dispersion de la phase des contributions apportées par chaque particule du corps 3 au signal global. Au bout d'une durée $T_E$ ces contributions sont de nouveau en phase, le signal S retrouve momentanément une valeur sensible. La séquence ainsi effectuée est une séquence dite avec échos de spin. On peut répéter avec des impulsions radiofréquences 16 et 17 cette réflexion de la dispersion de phase un certain nombre de fois. Le signal S mesuré est inscrit dans une enveloppe 18 indiquant une décroissance exponentielle dont la constante de temps $T_2$ est une des caractéristiques du signal que l'on cherche à mesurer. Dans les intervalles de temps qui séparent les dates d'application des impulsions radiofréquences des dates auxquelles on mesure le signal S on applique les gradients (19) de codage.

Au bout d'une durée $T_r$ une autre séquence est entreprise. Les excitations radiofréquences sont successivement répétées de la même manière. Le signal S est également mesuré dans les mêmes conditions. Par contre, au cours de cette autre séquence, les valeurs des gradients de codage sont modifiées pour créer une dimension supplémentaire d'information dans le signal reçu. Sans entrer dans le détail des procédés d'imagerie, il faut savoir qu'un certain nombre de séquences sont ainsi effectuées. Ce nombre de séquences est d'autant plus élevé que la résolution de l'image attendue doit être fine. Dans un exemple, pour une image, il y a 256 séquences successives dont la durée $T_r$ vaut environ 300 millisecondes. La durée de chaque séquence $T_r$ n'est pas sans influence dans le phénomène de résonance magnétique nucléaire. En fonction des régions à imager, ou en fonction des natures de tissus discriminés dans le corps, on choisit $T_r$. Sa valeur peut donc être ajustée.

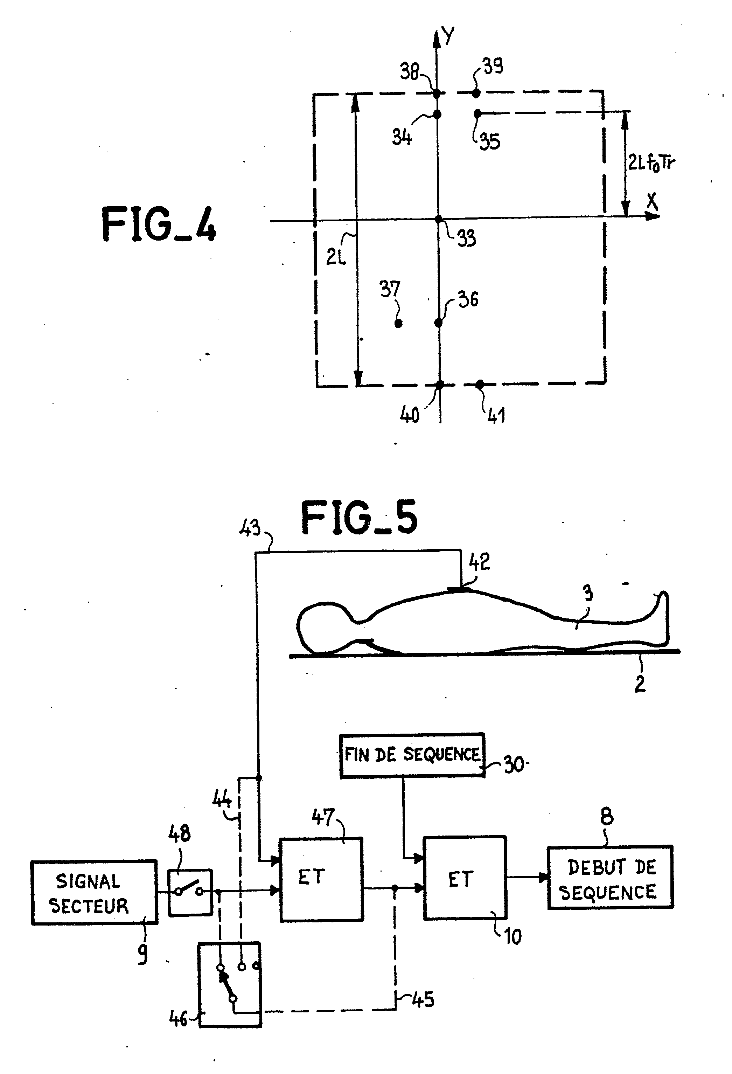

La figure 3 représente un diagramme fonctionnel d'un exemple de réalisation de moyens de synchronisation selon l'invention. Dans le séquenceur 8 une mémoire pré-programmée 21 comporte des instructions relatives à l'activation des moyens d'excitation radiofréquence, de réception du signal de résonance, et d'application des gradients de champ. Les instructions de la mémoire 21 sont débitées à un rythme imposé par un compteur-décompteur 22 qui, à chaque séquence, est conditionné par les instructions disponibles dans un registre 23. Des moyens 24 permettent d'ajuster les paramètres de séquence. Par exemple, les moyens 24 permettent de déterminer le nombre d'excitations d'écho 15 à 17 à mettre en oeuvre, ainsi que la durée $T_E$ qui les séparent les unes des autres. Le décompteur 22 décompte au rythme d'une horloge 25. Un compteur-décompteur 26 conditionné par un registre 27 valide, en fonction d'une durée $T_r$ choisie, le fonctionnement du compteur 22. La validation emprunte une liaison 28. Le décompteur 26 décompte aussi au rythme de l'horloge 25. Des moyens 29 ressemblant aux moyens 24 permettent à un opérateur d'ajuster la durée $T_r$ de chaque séquence. Ce qui caractérise l'invention est la présence dans la connexion 28 d'une fonction logique ET entre un signal secteur délivré par les moyens 9 et un signal délivré par une sortie 30 du décompteur 26 quand celui-ci a mesuré la durée $T_r$ ajustée.

Le fonctionnement de ces moyens de synchronisation est le suivant. Avant la mise en service, la sortie 30 du décompteur 26 est à un état 1. Lors du démarrage, par exemple par fermeture d'un interrupteur 31, une impulsion 32 du signal secteur est appliquée sur une deuxième entrée d'une bascule logique exécutant une fonction ET dans les moyens 10. La connexion 28 transmet alors cet état aux décompteurs 22 et 26. A l'arrivée de cette impulsion, chaque décompteur est remis à zéro (RAZ), se charge (se conditionne) en fonction du contenu du registre 23 ou 27 respectivement, et donne le départ à son décomptage. Une séquence est alors exécutée selon les instructions de la mémoire 21. A la fin de cette séquence, le décompteur 22 s'arrête. Dès le début de son décomptage, la sortie 30 du décompteur 26 passe à l'état zéro. Aucune impulsion du signal secteur ne peut alors passer dans la connexion 28. Lorsque le décompteur 26 a terminé son décomptage, sa sortie 30 repasse à un état 1. La bascule logique ET est alors disponible pour permettre l'exécution d'une séquence suivante dès la réception d'une prochaine impulsion 32 du signal de secteur. Dans ces conditions, on assure que la durée $T_r$ effective est toujours proportionnelle à la période du signal secteur (quelle que soit la durée $T_r$ que l'on a ajustée avec les moyens 29). La durée $T_r$ vraie est donc égale à un multiple entier de la période du signal secteur. Elle est immédiatement supérieure à la durée ajustée en fonction d'une expérimentation désirée. Compte tenu des ordres de grandeur, 300 millisecondes pour la durée $T_r$ et 20 ms maximum pour la période du signal secteur, l'erreur ainsi apportée est minime. En effet, la modification des images qui résulte d'un choix particulier de $T_r$ n'est perceptible que si cette durée varie suffisamment. Par exemple sa variation est dans un rapport 3 environ : elle passe de 300 millisecondes à une seconde.

La figure 4 représente une image de hauteur 2L organisée selon deux axes X et Y. Dans l'invention on a découvert qu'une image 33, par exemple d'un point élémentaire, est associée à des fantômes décalés 34, 35 et 36, 37. On a mesuré le décalage et on s'est rendu compte que les fantômes 34 et 35 sont placés à une ordonnée $2L.f_0.T_r$. Les fantômes 36 et 37 sont placés à une ordonnée de valeur égale. Les fantômes 34 et 36 ont la même abscisse que l'image vraie 33 et les fantômes 35 et 37 ont des abscisses décalés respectivement en avant et en arrière de l'abscisse de l'image normale 33. Si on fait varier $T_r$ et si on le choisit tel que $f_0.T_r$ soit égal à un demi moins $\varepsilon$ les fantômes 34 et 35 sont placés tout en haut de l'image en 38, 39. Si on choisit $f_0.T_r$ égal à un demi plus $\varepsilon$ ces fantômes réapparaissent tout en bas de l'image en 40, 41. Ils se sont rebouclés sur l'image. Autrement dit, pour $f_0.T_r$ égal à un demi, les fantômes du centre de l'image sont renvoyés sur les bords de l'image. Ce résultat qui est déjà satisfaisant en soi pour tous les points d'image situés au centre n'est par contre pas satisfaisant pour les points d'image qui ont une ordonnée non nulle. Pour ceux-ci leurs fantômes apparaissent dans l'image. Dans l'invention, on s'est arrangé pour faire $f_0.T_r$ égal à $\underline{n}$ où $\underline{n}$ est un nombre entier. Autrement dit, en faisant varier $T_r$ on fait en sorte que le fantôme 34 de l'image 33 passe successivement par les positions 38, 40, et qu'il vienne ensuite se placer exactement en 33. Après $\underline{n}$ rotations, chaque fantôme occupe alors la place de l'image qu'il perturbe. Il en résulte que les fantômes quand ils apparaissent, sont quasiment invisibles : ils ne gênent plus.

Dans l'explication qui précède on a examiné le sort des fantômes liés au fondamental de $f_0$. C'est alors un résultat remarquable de l'invention que les fantômes liés à des harmoniques de $f_0$ sont neutralisés automatiquement de la même manière. En effet, pour ces harmoniques de fréquence $f'_0$, $f'_0$ vaut $m.f_0$ où $\underline{m}$ est un entier. La condition $f'_0.T_r$ égal à $\underline{n}$ entier est alors automatiquement remplie pour eux.

Les fantômes 35 et 37 apparaissent cependant toujours dans l'image : leur ordonnée est maintenant la même que celle de l'image normale. Leur abscisse est différente. Ils ont pour effet de surligner les contours des images : c'est moins gênant. Ils peuvent être interprétés, à tort, comme l'effet d'un déplacement chimique. En effet, la composition chimique des tissus est telle que les particules ne voient pas que le champ $B_0$, mais un champ $B_0$ augmenté d'une composante magnétique liée à la présence des atomes qui organisent les molécules qui les composent. Il peut en résulter une variation de la fréquence du signal de résonance qui, après traitement par transformée de Fourier pour traiter l'image, est aussi équivalente à un écho d'image latéral.

La figure 5 représente une application particulière de l'invention. Dans celle-ci on cherche à donner une image du corps dans une région comportant un organe mobile. Chez un homme, cet organe mobile est par exemple le coeur. Il est connu de synchroniser le début des séquences d'imagerie avec un signal provenant d'un détecteur 42 qui détecte le passage du corps 3 d'un état à un autre : par exemple de la diastole à la systole. Le signal du détecteur 42 est envoyé par des connexions 43, 44, et 45 à des moyens de synchronisation (identiques à ceux de l'invention) recevant une information de fin de séquence pour n'autoriser, qu'à des dates bien précises, le début de séquences suivantes. Dans une réalisation simplifiée, et pour un appareil qui comporte déjà un tel aménagement, il suffit d'interposer un commutateur-interrupteur 46 dans la connexion 44, 45. Ce commutateur permet le remplacement du signal délivré par le détecteur 42 par un signal secteur délivré par les moyens 9. Moyennant cette modification très simple, il est possible d'éliminer dans les images les fantômes aléatoires.

Dans une variante préférée cependant, les moyens de synchronisation relatifs au mouvement du corps d'une part et relatifs aux fantômes du secteur d'autre part sont dédoublés. Les deux moyens peuvent être agencés en cascade l'un de l'autre. Par exemple, les moyens de synchronisation 10 relatifs aux fantômes secteur reçoivent, à la place du signal secteur, un signal produit par des moyens 47 de synchronisation sur les mouvements du corps 3. Ces moyens 47 reçoivent, eux, en entrée le signal du détecteur 42 et le signal secteur délivré par les moyens 9. Dans cette configuration il peut apparaître néanmoins un inconvénient. En effet, il n'y a aucune raison pour que les organes du corps 3 soient synchronisés avec le signal secteur. En conséquence, les images obtenues reflètent le mouvement du corps 3 pendant la durée d'une période du signal secteur. Par exemple pour un battement cardiaque à 2 hertz, de période 500 millisecondes l'erreur de calage en synchronisation de l'ordre de 20 millisecondes représente 4 % de la durée de ce battement. Si l'image désirée correspond à un paroxysme de vitesse du mouvement, elle peut en être troublée. Dans ce cas, il faut faire le choix entre une image sans fantôme mais éventuellement floue, et une image avec fantômes mais pure. Des moyens de commutation supplémentaire, tels que le commutateur-interrupteur 46 associé à un interrupteur 48 en série avec les moyens 9, peuvent permettre ce choix.

## Revendications

1. Appareil d'imagerie par résonance magnétique nucléaire comportant des moyens (1) pour soumettre un corps (3) à un champ ($B_0$) magnétique continu intense, des moyens (4) pour le soumettre à des séquences d'excitation électromagnétique, des moyens (5) pour lui appliquer au cours des séquences des champs magnétiques supplémentaires, et des moyens (6,7) pour recevoir, traiter, et représenter un signal de résonance magnétique émis en réponse par le corps, caractérisé en ce qu'il comporte des moyens (10) de synchronisation pour que les durées $T_r$ des séquences soient des multiples n entiers de la période ($1/f_0$) d'un signal alternatif de puissance qui sert d'alimentation (9) électrique à l'appareil.

2. Appareil selon la revendication 1, caractérisé en ce que les moyens de synchronisation comportent une bascule logique (10) dont la sortie commande le lancement des séquences pour exécuter une fonction logique ET entre un signal de fin de séquence et un signal synchrone du signal de puissance.

3. Appareil selon la revendication 2, caractérisé en ce qu'il comporte des moyens pour que le signal synchrone du signal de puissance soit produit par des moyens (47) pour exécuter une fonction logique ET entre un signal relatif à un passage d'un organe dudit corps (3) d'un état à un autre et un signal calé en phase par rapport au signal de puissance.

4. Appareil selon la revendication 1, caractérisé en ce qu'il comporte des moyens pour que le signal produit par les moyens (10) de synchronisation soit introduit dans des moyens (47) pour exécuter une fonction logique (ET) entre un signal relatif à un passage d'un organe dudit corps (3) d'un état à un autre et un signal calé en phase par rapport au signal de puissance, le signal produit par ces moyens servant de signal de synchronisation.

5. Appareil selon la revendication 3 ou la revendication 4, caractérisé en ce qu'il comporte des moyens (47, 46) pour choisir de mettre en oeuvre ou non les moyens de synchonisation (10).

## Patentansprüche

1. Gerät zur Bilderzeugung durch magnetische Kernresonanz, das Mittel (1), um einen Körper (3) einem intensiven magnetischen Gleichfeld ($B_0$) auszusetzen, Mittel (4), um ihn elektromagnetischen Anregunssequenzen zu unterwerfen, Mittel (5), um auf ihn beim Ablauf der Sequenzen zusätzliche magnetische Felder anzuwenden, und Mittel (6, 7) enthält, um ein Signal der magnetischen Resonanz, ausgesandt als Reaktion von dem Körper, zu empfangen, zu verarbeiten und darzustellen, dadurch gekennzeichnet, daß es Synchronisationsmittel (10) enthält, damit die Zeitintervalle $T_r$ der Sequenzen ganze Vielfache der Periode eines Leistungswechselsignals $1/f_0$ sind, das dem Gerät als elektrische Versorgung (9) dient.

2. Gerät nach Anspruch 1, dadurch gekennzeichnet, daß die Synchronisationsmittel eine logische Kippschaltung (10) enthalten, deren Ausgang den Start der Sequenzen steuert, um eine logische AND-Funktion zwischen einem Sequenzendesignal und einem Synchronsignal des Leistungssignals auszuführen.

3. Gerät nach Anspruch 2, dadurch gekennzeichnet, daß es Mittel enthält, damit das Synchronsignal des Leistungssignals durch Mittel (47) erzeugt wird, um eine logische AND-Funktion zwischen einem Signal, bezogen auf einen Übergang eines Organs eines Körpers (3) von einem Zustand in einen anderen, und einem in bezug auf das Leistungssignal phasengekoppelten Signal auszuführen.

4. Gerät nach Anspruch 1, dadurch gekennzeichnet, daß es Mittel enthält, damit das durch die Synchronisierungsmittel (10) erzeugte Signal in die Mittel (47) eingeleitet wird, um eine logische (AND-)Funktion zwischen einem Signal, bezogen auf den Übergang eines Organs des Körpers (3) von einem Zustand zu einem anderen, und einem in bezug auf das Leistungssignal phasengekoppelten Signal auzuführen, wobei das durch diese Mittel erzeugte Signal als Synchronisationssignal dient.

5. Gerät nach Anspruch 3 oder nach Anspruch 4, dadurch gekennzeichnet, daß es Mittel (47, 46) enthält, um auszuwählen, ob die Synchronisationsmittel (10) in Betrieb gesetzt werden oder nicht.

## Claims

1. A nuclear magnetic resonance image producing apparatus comprising means (1) in order to submit a body (3) to a continuous intense magnetic field ($B_0$), means (4) to submit it to electromagnetic excitation sequences, means (5) to apply supplementary magnetic fields to it in the course of the sequences, and means (6 and 7) to receive, process and indicate a magnetic resonance signal emitted in response by the body, characterized in that it comprises synchronizing means (10) to ensure that the durations $T_r$ of the sequences are entire multiples n of the cycle of the alternating signal of the power which serves for electrically supplying (9) the apparatus.

2. The apparatus as claimed in claim 1, characterized in that the synchronizing means comprise a logical balance (10) whose output controls the production of the sequences in order to execute a logical function ET between an end of sequence signal and a sync signal of the power signal.

3. The apparatus as claimed in claim 2, characterized in that it comprises means to ensure that the sync signal of the power signal is produced by means (47) in order to execute a logical function ET between a signal relative to a transition of an organ of the said body (3) from one state to another and a signal which is phase shifted in relation to the power signal.

4. The apparatus as claimed in claim 1, characterized in that it comprises means to ensure that the signal produced by the synchronizing means (10) is introduced into means (47) in order to execute a logical function (ET) between a signal relative to a transition of an organ of the said body (3) from one state to another and a signal shifted in phase in relation to the power signal, the signal produced by these means serving as a synchronization signal.

5. The apparatus as claimed in claim 3 or claim 4, characterized in that it comprises means (47 and 46) in order to select whether the synchronizing means (10) are to be put into operation or not.

# FIG_1

# FIG_3

# FIG_2

EP 0 227 512 B1

## FIG_4

$2Lf_0Tr$

$2L$

X

Y

38  39
34  35
33
37  36
40  41

## FIG_5

43

42

3

2

FIN DE SEQUENCE  30

44

47

48

SIGNAL
SECTEUR

ET

ET

DEBUT DE
SEQUENCE

8

10

9

46

45